# EUROPEAN PATENT APPLICATION

(11) **EP 2 811 632 A1**
(43) Date of publication of application: **10.12.2014**
(21) Application number: 13743481.7
(22) Date of filing: 22.01.2013
(51) Int. Cl.: H02M 1/08

(54) **DRIVE CIRCUIT FOR SEMICONDUCTOR SWITCHING ELEMENT AND POWER CONVERSION CIRCUIT USING SAME**

(30) Priority: 03.02.2012 JP 2012021464
(71) Applicant: Hitachi, Ltd., Tokyo 100-8280 (JP)
(72) Inventor: OGAWA, Kazutoshi, Chiyoda-ku, Tokyo 100-8280 (JP); ISHIKAWA, Katsumi, Chiyoda-ku, Tokyo 100-8280 (JP)
(74) Representative: MERH-IP Matias Erny Reichl Hoffmann
(86) International application number: PCT/JP2013/051142
(87) International publication number: WO 2013/115000

(57) **Abstract**

Ringing is securely reduced in a case where a Schottky barrier diode of a wide-gap semiconductor is applied to a power conversion circuit. A gate voltage increasing circuit 11a is included. In a period since a gate voltage of a semiconductor switching element in one of upper and lower arms starts being increased from a value in an off-state until the gate voltage reaches a value in an on-state, the gate voltage increasing circuit 11a is configured to make a gate voltage of the semiconductor switching element in the other one of the upper and lower arms change from a value in an off-state into a value larger than the value in the off-state and is configured to control the value larger than the value in the off-state for a predetermined period of time.

## Description

### Technical Field

The present invention relates to a drive circuit of a semiconductor switching element in a power conversion circuit using a Schottky barrier diode of a wide-gap semiconductor.

### Background Art

Recently, silicon carbide (SiC), gallium nitride (GaN), or the like has been attracting attention as a wide-gap semiconductor material having larger band gap than silicon (Si). Since the wide-gap semiconductor material has about 10 times as much as dielectric breakdown electric field strength of Si, a thickness of a drift layer for securing a withstand voltage in a semiconductor element including the wide-gap semiconductor material as a base material can be about 1/10 of that of Si. Thus, it is possible to make an on-state voltage of a semiconductor element lower. Thus, even in a high withstand voltage region in which a bipolar element can only be used in a case of Si, a unipolar element can be used and high-speed switching becomes possible in a case of a wide-gap semiconductor element such as SiC.

In the following, SiC which represents the wide-gap semiconductor will be described. However, a different wide-gap semiconductor is in a similar manner.

To a power semiconductor module used in a power conversion circuit such as an inverter, a freewheel diode is connected in parallel with a semiconductor switching element. In a conventional power semiconductor module, an Si-PiN diode has been used as a freewheel diode. The Si-PiN diode is a bipolar-type semiconductor element and includes a structure in which when energization is performed with a large current in a forward bias, a voltage drop becomes low due to a conductivity modulation. However, the PiN diode has a characteristic in which a carrier remaining in the PiN diode due to a conductivity modulation generates a reverse recovery current during a process of a change from the forward bias state to a reverse bias state. In the PiN diode of Si, the remaining carrier has a long life, and thus, the reverse recovery current becomes large. Thus, due to the reverse recovery current, a loss during a semiconductor switching element being turned on (Eon) or a recovery loss generated when a diode performs reverse recovery (Err) becomes large.

Next, a terminal voltage and a current waveform of a diode during the generation of a reverse recovery current will be described.

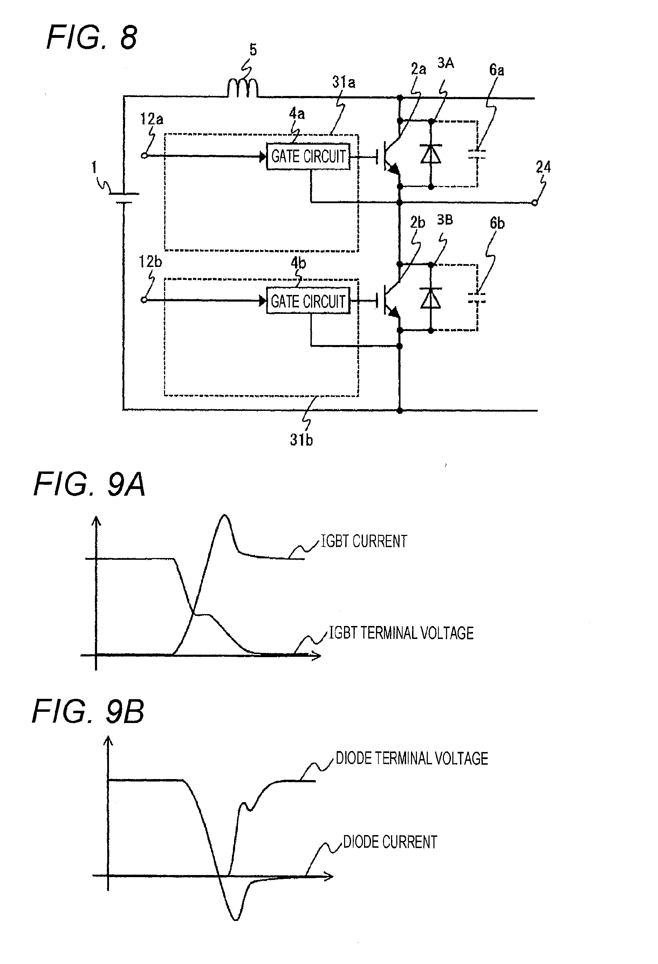

FIG. 8 is a view illustrating a conventional power conversion circuit in which each of upper and lower arms includes an insulated gate bipolar transistor (hereinafter, referred to as IGBT), which is a semiconductor switching element, and a PiN diode. The conventional power conversion circuit includes a drive circuit of each IGBT. FIG. 9A and FIG. 9B are views for describing a terminal voltage and a current waveform of a diode during the generation of a reverse recovery current in the power conversion circuit in FIG. 8. In a main circuit of an inverter of a power module using a conventional PiN diode, by a product of a current change (reverse recovery di/dt) during decay of a reverse recovery current of the PiN diode and a parasitic inductance L in the main circuit, a commutation surge voltage (ΔVp = L × reverse recovery di/dt) is added. When the sum (E + ΔVp) of a source voltage (E) and a surge voltage (ΔVp) exceeds a withstand voltage of an IGBT, the IGBT may get broken. Thus, various techniques to reduce a parasitic inductance or a noise of a main circuit have been proposed.

On the other hand, a Schottky barrier diode (hereinafter, referred to as SBD) is a unipolar-type semiconductor element and a carrier is rarely generated therein by a conductivity modulation. Thus, when the Schottky barrier diode is used in an inverter circuit, a reverse recovery current is very small, and thus, a turn-on loss or a recovery loss can be made small. Conventional Si has low dielectric breakdown electric field strength. Thus, when an SBD is manufactured in a structure with a high withstand voltage, high resistance is generated during energization, and thus, a limit of a withstand voltage of an Si-SBD has been about 200 V. However, since SiC has 10 times as much as the dielectric breakdown electric field strength of Si, it has been known that it becomes possible to put an SBD with a high withstand voltage into a practical use and to reduce a loss during turn-on (Eon) or a recovery loss generated when a diode performs a reverse recovery (Err).

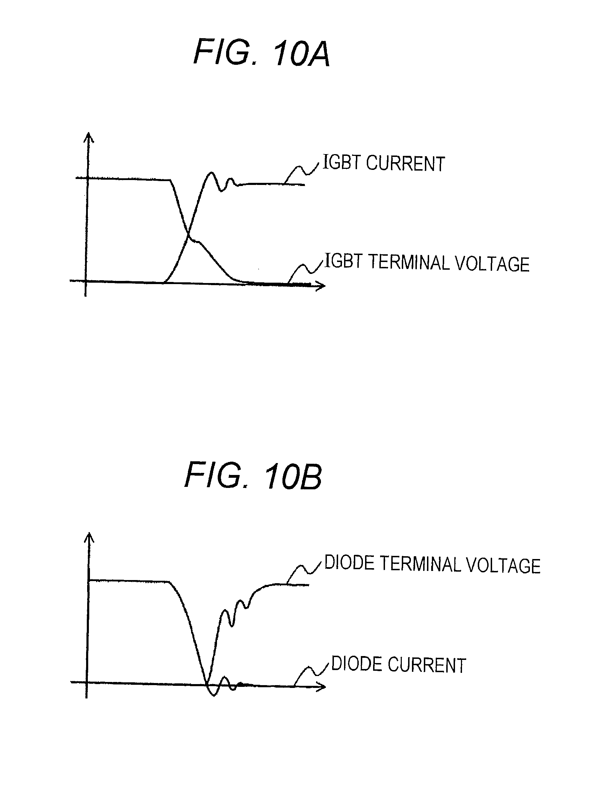

However, in a case where the SiC-SBD is applied to a circuit, when a semiconductor switching element of an own arm is turned on, a source voltage is applied to a terminal of a diode of an opposite arm. By junction capacitance of the diode and a parasitic inductance of a main circuit, a resonance current flows and a voltage oscillation or a voltage change rate during switching becomes larger than that of the PiN diode. FIG. 10A and FIG. 10B are views for describing a terminal voltage and a current waveform of a diode when an SiC-SBD is applied. When the voltage oscillation or the voltage change rate is increased, an increase in a noise level and deterioration of a motor insulating material are concerned. Thus, a reduction technique is necessary.

In an inverter in which the PiN diode is applied, as a method to reduce a surge voltage, there is a method to turn on, during a recovery period of a diode, a semiconductor switching element connected in parallel with the recovering diode and to short-circuit upper and lower arms momentarily. Thus, as a method to perform a short-circuit operation when a surge voltage is increased to a vicinity of a withstand voltage of an element, the following two methods are proposed.

In PTL 1, a method to perform a short-circuit by detecting a terminal voltage of a switching element and charging gate capacitance with a current source when the terminal voltage reaches a threshold is proposed.

In PTL 2, a method to perform a short-circuit by charging a gate of an IGBT during generation of recovery in an active clamp circuit which connects a Zener diode between a collector terminal and a gate terminal of the IGBT is proposed.

### Citation List

### Patent Literature

PTL 1: JP 2003-218675 A
PTL 2: JP 2005-328668 A

### Summary of Invention

### Technical Problem

A voltage oscillation and a voltage change rate during switching are increased in an SiC-SBD, compared to those in a PiN diode. However, PTL 1 and PTL 2 of the conventional techniques are effective only when a surge voltage is increased to a vicinity of a withstand voltage of an element. When the SiC-SBD is applied, the voltage oscillation becomes large even when the surge voltage is small, and thus, it is hard to control the voltage oscillation.

The present invention has been made in consideration of the above problem, and a purpose of thereof is to provide a drive circuit of a semiconductor switching element, the drive circuit being capable of reducing a voltage oscillation securely when an SBD of a wide-gap semiconductor is applied to a power conversion circuit.

### Solution to Problem

A drive circuit of a semiconductor switching element according to the present invention is configured to control a gate voltage of a semiconductor switching element in each of upper and lower arm circuits in each of which a Schottky barrier diode including a wide-gap semiconductor material as a base material is connected as a freewheel diode in parallel with the semiconductor switching element. To solve the above problem, the drive circuit includes a gate voltage increasing circuit configured to make, in a period since a gate voltage of the semiconductor switching element in one of the upper and lower arms starts being increased from a value in an off-state until the gate voltage reaches a value in an on-state, a gate voltage of the semiconductor switching element in the other one of the upper and lower arms change from a value in an off-state into a value larger than the value in the off-state and configured to control the value larger than the value in the off-state for a predetermined period of time.

### Advantageous Effects of Invention

By increasing, before a current starts flowing in a semiconductor switching element of one of upper and lower arms, a gate voltage of a semiconductor switching element in the other arm and by short-circuiting the upper and lower arms, it is possible to securely reduce a voltage oscillation in a power conversion circuit to which a Schottky barrier diode including a wide-gap semiconductor material as a base material is applied.

### Brief Description of Drawings

[FIG. 1] FIG. 1 is a view illustrating a power conversion circuit and a drive circuit of an embodiment of the present invention.
[FIG. 2A] FIG. 2A is a chart of an example of current and voltage waveforms illustrating an operation of the drive circuit.
[FIG. 2B] FIG. 2B is a chart of an example of current and voltage waveforms illustrating an operation of the drive circuit.
[FIG. 2C] FIG. 2C is a chart of an example of current and voltage waveforms illustrating an operation of the drive circuit.
[FIG. 2D] FIG. 2D is a chart of an example of current and voltage waveforms illustrating an operation of the drive circuit.
[FIG. 3] FIG. 3 is a view illustrating an example of a detail circuit configuration of the drive circuit.
[FIG. 4] FIG. 4 is a view illustrating a power conversion circuit and a drive circuit of a different embodiment of the present invention.
[FIG. 5] FIG. 5 is a view illustrating a power conversion circuit and a drive circuit of a different embodiment of the present invention.
[FIG. 6] FIG. 6 is a chart illustrating current dependency of a surge voltage and a voltage change rate.
[FIG. 7] FIG. 7 is a view illustrating a power conversion circuit and a drive circuit of a different embodiment of the present invention.
[FIG. 8] FIG. 8 is a view illustrating a conventional power conversion circuit and drive circuit.
[FIG. 9A] FIG. 9A is a chart illustrating current and voltage waveforms of a power conversion circuit to which an Si-PiN is applied.
[FIG. 9B] FIG. 9B is a chart illustrating current and voltage waveforms of the power conversion circuit to which the Si-PiN is applied.
[FIG. 10A] FIG. 10A is a chart illustrating current and voltage waveforms of a power conversion circuit to which an SiC-SBD is applied.
[FIG. 10B] FIG. 10B is a chart illustrating current and voltage waveforms of the power conversion circuit to which the SiC-SBD is applied.

### Description of Embodiments

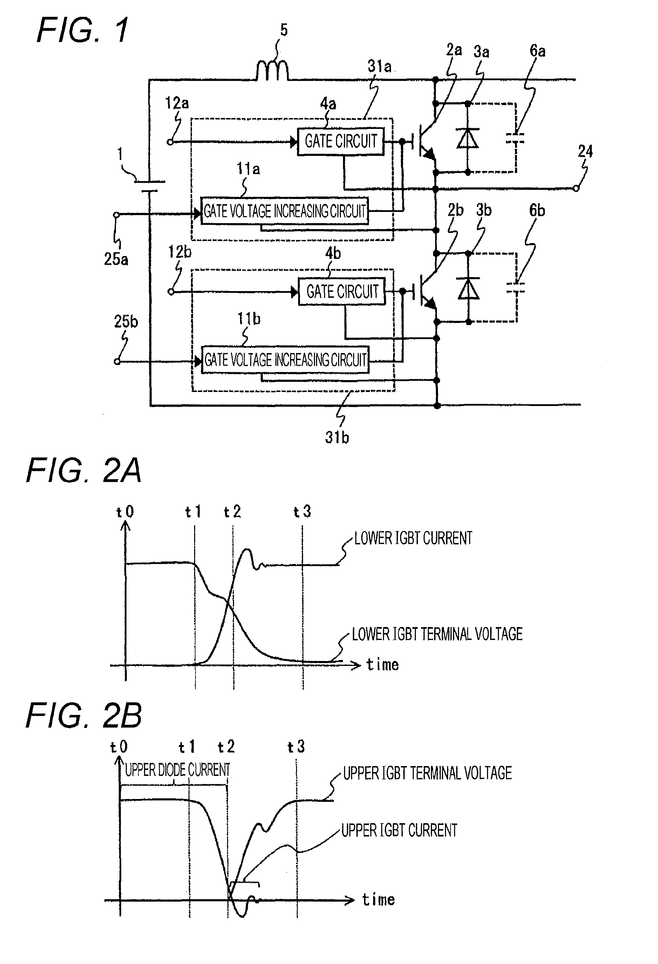

FIG. 1 is a view illustrating a power conversion circuit and a drive circuit of an embodiment of the present invention.

In the present power conversion circuit, as a switching element, an IGBT 2a and an IGBT 2b are connected to each other in series. A serially connected circuit of the IGBT 2a and the IGBT 2b configures a half-bridge circuit of one phase. Both ends of the serially connected circuit are connected to a DC power source 1 and a series connection point is connected to an AC output terminal 24. To the IGBT 2a and the IGBT 2b, as freewheel diodes, an SiC-SBD 3a and an SiC-SBD 3b are respectively connected in parallel. That is, an upper arm including a parallel circuit of the IGBT 2a and the SiC-SBD 3a and a lower arm including a parallel circuit of the IGBT 2b and the SiC-SBD 3b are connected in series. Both ends of the serially connected circuits of the upper and lower arms are connected to the DC power source 1 and the series connection point is connected to the AC output terminal 24. Here, the upper arm is connected between a high-voltage side of the DC power source 1 and the AC output terminal 24. The lower arm is connected to the AC output terminal 24 and a low-voltage side of the DC power source 1.

To the IGBT 2a and the IGBT 2b, a drive circuit 31a and a drive circuit 31b are respectively connected to control a gate voltage. The drive circuit 31a includes a gate circuit 4a to control a gate voltage of the IGBT 2a according to a switching control signal given to a gate control signal terminal 12a, and a gate voltage increasing circuit 11a to perform a short-circuit drive by increasing the gate voltage of the IGBT 2a according to a short-circuit control signal given to a short-circuit control signal terminal 25a. Similarly, the drive circuit 31b includes a gate circuit 4b to control a gate voltage of the IGBT 2b according to a switching control signal given to a gate control signal terminal 12b, and a gate voltage increasing circuit 11b to perform a short-circuit drive for a temporary arm short-circuit by increasing the gate voltage of the IGBT 2b according to a short-circuit control signal given to a short-circuit control signal terminal 25b.

The power conversion circuit of the present embodiment converts DC power of the DC power source 1 into AC power by performing on-off switching control on the IGBT 2a and the IGBT 2b respectively by the drive circuits 31a and 31b. The AC power is output from the AC output terminal 24 and is supplied to a load such as an induction motor or a permanent-magnetic motor which is connected to the AC output terminal 24. Note that in FIG. 1, the upper and lower arms of one phase are illustrated. However, actually, the power conversion circuit includes upper and lower arms the number of which corresponds to the number of phases of the load. For example, in a case of a three-phase AC motor, the power conversion circuit includes three pairs of serially connected circuits of the upper and lower arms.

Note that in FIG. 1, for description of a circuit operation described later, a parasitic inductance of main circuit wiring is referred to as an inductance 5. Also, junction capacitance of the SiC-SBD 3a is referred to as a capacitor 6a and that of the SiC-SBD 3b is referred to as a capacitor 6b.

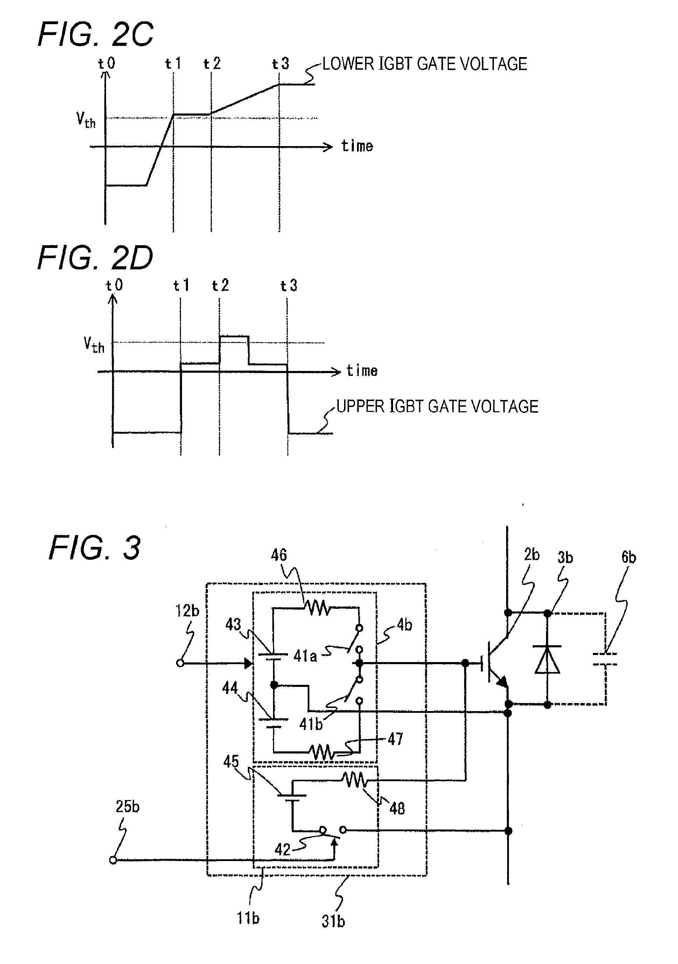

FIG. 2A to FIG. 2D are charts of examples of current and voltage waveforms illustrating an operation of the drive circuit according to the present embodiment. Description can be made in respect to a turn-on operation (transition from being off to being on) of either the IGBT 2a or the IGBT 2b in FIG. 1. Here, a case of turning on the IGBT 2b will be described'. Note that in FIG. 2A to FIG. 2D, an "upper IGBT" indicates an IGBT of the upper arm, that is, the IGBT 2a and an "upper diode" indicates a diode of the upper arm, that is, the SiC-SBD 3a. A "lower IGBT" indicates an IGBT of the lower arm, that is, the IGBT 2b. Also, Vth indicates gate threshold voltages of the IGBT 2a and the IGBT 2b. Also, a current waveform in FIG. 2B indicates a waveform of a current flowing in the upper arm, that is, a current in which a current flowing in the "upper IGBT" and a current flowing in the "upper diode" are combined. Note that since it is assumed that the current flowing in a forward direction of the "upper diode" is a positive current, the current flowing in the upper IGBT is indicated as a negative current.

When the lower IGBT (2b) is turned on, a current flowing in the SiC-SBD 3a is decreased and a current starts flowing in the lower IGBT (2b) being turned on. Then, when the current flowing in the SiC-SBD 3a becomes zero, the SiC-SBD 3a is turned off (transitions from being on to being off). In a case of the SiC-SBD, a high recovery current such as that in the PiN diode does not flow. When being turned off, the SiC-SBD 3a operates as a capacitor by the junction capacitance 6a. Thus, by energy stored in the inductance 5 in FIG. 1, an LC resonance current flows and ringing is generated.

In the present embodiment, in a period since a gate-emitter voltage (hereinafter, referred to as "gate voltage") of the lower IGBT (2b) starts changing into a value larger than a voltage in an off-state, that is, since the gate voltage starts being increased until the gate voltage reaches a gate voltage in an on-state, a gate voltage of the upper IGBT (2a) connected in parallel with the SiC-SBD 3a being turned off is controlled to a value larger than a voltage in an off-state by the gate voltage increasing circuit 11a. Specifically, in a case of FIG. 2A to FIG. 2D, when a value of the gate voltage of the lower IGBT (2b) becomes equal to or larger than a threshold (Vth) from a negative voltage in the off-state (t1), the gate voltage of the upper IGBT (2a) is increased from the negative voltage in the off-state to a positive voltage lower than the threshold (Vth). Then, when a current of the SiC-SBD 3a becomes around zero and a terminal voltage of the upper IGBT (2a), that is, a voltage of the SiC-SBD 3a is increased, even in a case where the gate voltage of the upper IGBT (2a) is controlled to a positive voltage lower than the threshold (Vth) by the gate voltage increasing circuit 11a, the gate voltage is increased to be equal to or higher than the threshold (Vth) by a displacement current which flows in gate capacitance of the upper IGBT (2a) along with a voltage increase in the SiC-SBD 3a, that is, a voltage increase in the upper IGBT (2a). Thus, the upper IGBT (2a) is turned on (t2).

In the present embodiment, the gate voltage of the upper IGBT (2a) is controlled to a value larger than that in the off-state before a current start flowing in the lower IGBT (2b) . Thus, when the displacement current starts flowing (t2), the gate voltage of the upper IGBT (2a) can be securely made equal to or higher than the threshold. Thus, a ringing oscillation can be controlled securely.

When the upper IGBT (2a) is turned on, a current by the energy stored in the inductance 5 starts flowing through the upper IGBT (2a). Here, since the upper IGBT (2a) operates as a resistance component, the ringing oscillation is controlled and a surge voltage and a noise level can be reduced. Then, when the gate voltage of the lower IGBT (2b) reaches a gate source voltage (t3), the gate voltage of the upper IGBT (2a) is controlled to the voltage in the off-state again. Thus, an increase in a power loss caused in the upper IGBT (2a) by a flow of a short-circuit current due to the turn-on of the upper IGBT (2a) and a turn-on loss in the lower IGBT (2b) can be controlled.

In the described embodiment, the upper IGBT (2a) is turned on by making the gate voltage equal to or higher than the threshold by the displacement current. However, a point when the displacement current starts flowing may be detected based on the voltage of the SiC-SBD 3a or the upper IGBT (2a) or the gate voltage of the lower IGBT (2b) and when the displacement current starts flowing, the gate voltage of the upper IGBT (2a) may be set to a voltage value equal to or larger than the threshold (Vth) for a predetermined period of time by the gate voltage increasing circuit 11a.

Note that at least in a period in which the voltage of the SiC-SBD 3a and the upper IGBT (2a), that is, the voltage of the upper arm is increased, that is, in a recovery period after the current (return current) flowing in the SiC-SBD 3a is decreased and becomes zero, ringing can be reduced by turning on the IGBT 2a with the gate voltage of the IGBT 2a being equal to or higher than the threshold.

Next, an example of a detail circuit configuration of the drive circuit illustrated in FIG. 1 is illustrated in FIG. 3. Here, only the upper arm and the drive circuit 31a of the IGBT 2a in the upper arm in FIG. 1 are illustrated, but the lower arm includes a similar circuit configuration.

The drive circuit 31a in FIG. 3 includes switches for a gate circuit 41a and 41b, a switch for short-circuit control 42, a gate circuit power supply in an on-state 43, a gate circuit power supply in an off-state 44, a power supply for a gate voltage increasing circuit 45, an on-side gate resistance 46, an off-side gate resistance 47, and a resistance for a gate voltage increasing circuit 48. When a short-circuit control signal is given to the short-circuit control signal terminal 25a, the switch for short-circuit control 42 is turned on. Here, by a switching control signal given to the gate control signal terminal 12a, the switch for a gate circuit 41a is in an off-state and the switch for a gate circuit 41b is in an on-state.

When the switch for short-circuit control 42 is turned on, the gate circuit power supply in an off-state 44 and the power supply for a gate voltage increasing circuit 45 are connected in series and a current flows in the off-side gate resistance 47 and the resistance for a gate voltage increasing circuit 48. By the current, a voltage drop is caused in the off-side gate resistance 47 and a summed value of a terminal voltage of the off-side gate resistance 47 and a voltage of the gate circuit power supply in an off-state 44 is applied to a gate of the IGBT 2a. The gate voltage at this time becomes higher than the gate voltage in the off-state. Here, an increased amount of the gate voltage is set by a voltage division ratio between the off-side gate resistance 47 and the resistance for a gate voltage increasing circuit 48. In such a manner, the gate voltage increasing circuit 11a in the present embodiment applies, to the gate of the IGBT 2a, a positive voltage lower than the gate threshold voltage.

When the gate voltage of the IGBT 2a becomes higher than the gate voltage in the off-state, as described, the current by the energy stored in the inductance 5 flows as a short-circuit current in the IGBT 2a and the IGBT 2b of the upper and lower arms. Thus, ringing due to a resonance current by the inductance 5 and the capacitor 6a (junction capacitance of SiC-SBD 3a) can be reduced.

Then, by the short-circuit control signal given to the short-circuit control signal terminal 25a, the switch for short-circuit control 42 is turned off. Thus, the gate voltage of the IGBT 2a is controlled to the voltage in the off-state again. Thus, as described, an increase in a power loss in the IGBT 2a caused by the short-circuit current and a turn-on loss in the IGBT 2b can be controlled.

In the present embodiment, the gate circuit power supply in an on-state 43 and the power supply for a gate voltage increasing circuit 45 are provided separately, but may be a single power supply. Also, as the switches for a gate circuit 41a and 41b and the switch for short-circuit control 42, a semiconductor switching element such as an MOSFET can be applied.

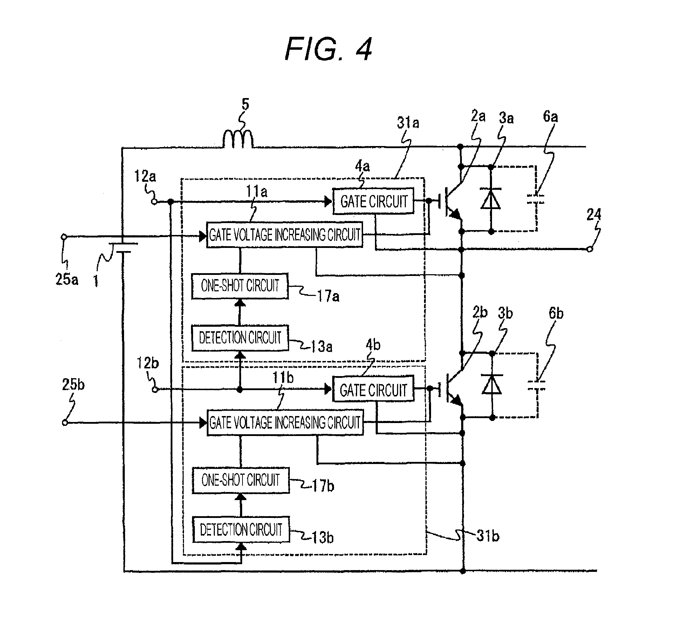

FIG. 4 is a view illustrating a power conversion circuit and a drive circuit of a different embodiment of the present invention. In the following, a point different from the described embodiment in FIG. 1 will be described.

In the present embodiment, by a one-shot circuit, a timing to make the gate voltage increasing circuit operate is controlled. For example, similarly to FIG. 2A to FIG. 2D, when an SiC-SBD 3a in an upper arm performs recovery, a switching signal given to a gate control signal terminal 12b of an IGBT 2b in a lower arm is detected by a detection circuit 13a included in a drive circuit 31a. According to the detected switching signal, a control signal to make the gate voltage increasing circuit 11a operate is created by a one-shot circuit 17a. By using the one-shot circuit in such a manner, it becomes possible to control an increase period of the gate voltage and to increase the gate voltage momentarily. Thus, ringing can be securely reduced.

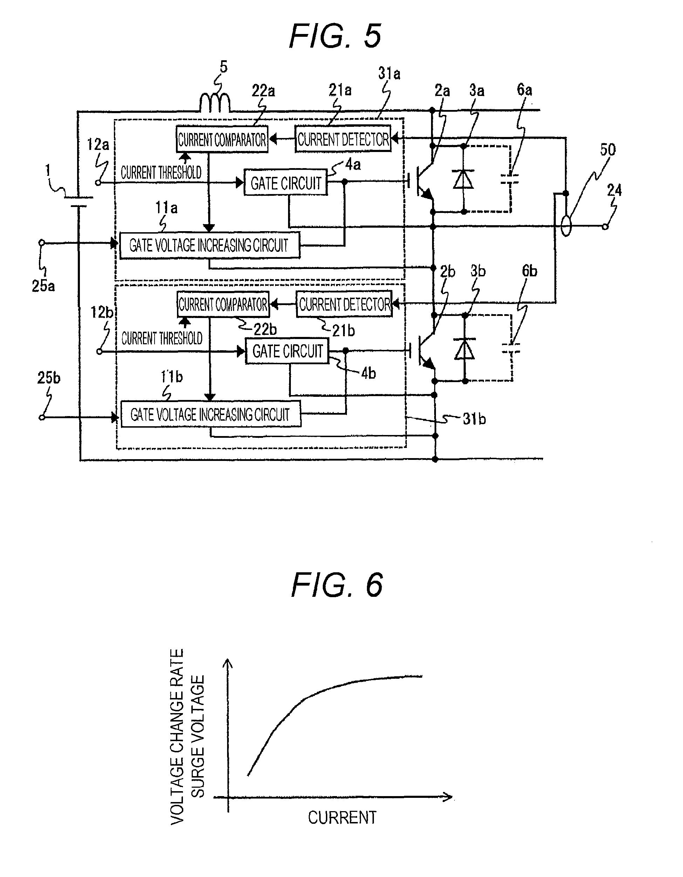

FIG. 5 is a view illustrating a power conversion circuit and a drive circuit of a different embodiment of the present invention. FIG. 6 is a view illustrating switching current dependency of a voltage change rate of a terminal voltage and a surge voltage after turn-off in respect to an SiC-SBD in the embodiment in FIG. 5. In the following, a point different from the described embodiments in FIG. 1 and FIG. 4 will be described.

As illustrated in FIG. 6, the larger the switching current (current which flows in IGBT or SiC-SBD in on-state) is, the higher the voltage change rate of the terminal voltage and the surge voltage after the turn-off of the SiC-SBD become. Also, the smaller the switching current is, the lower the voltage change rate of the terminal voltage and the surge voltage after the turn-off of the SiC-SBD become. Thus, even when the gate voltage increasing circuit is operated only in a region having a large switching current, it is possible to control a peak value of the voltage change rate or the surge voltage and ringing effectively.

Thus, in the present embodiment illustrated in FIG. 5, a current flowing in a load through an AC output terminal 24 is detected by a current sensor 50 such as a current transformer. A current detector 21a included in a drive circuit 31a outputs, based on an output signal from the current sensor 50, a detection signal corresponding to a current value of a current flowing in the load, that is, the switching current. A current comparator 22a compares a current value of the switching current indicated by the detection signal output from the current detector 21a and a current threshold set in advance. When determining that the current value of the switching current is equal to or larger than the current threshold, the current comparator 22a creates a control signal to enable an operation of the gate voltage increasing circuit 11a which operation corresponds to a short-circuit control signal given to a short-circuit control signal terminal 25a.

According to the present embodiment, the gate voltage increasing circuit operates in a case where the switching current is equal to or larger than the threshold set in advance. Thus, it is possible to control a power loss in the gate voltage increasing circuit while controlling a peak value of the voltage change rate or the surge voltage and ringing effectively.

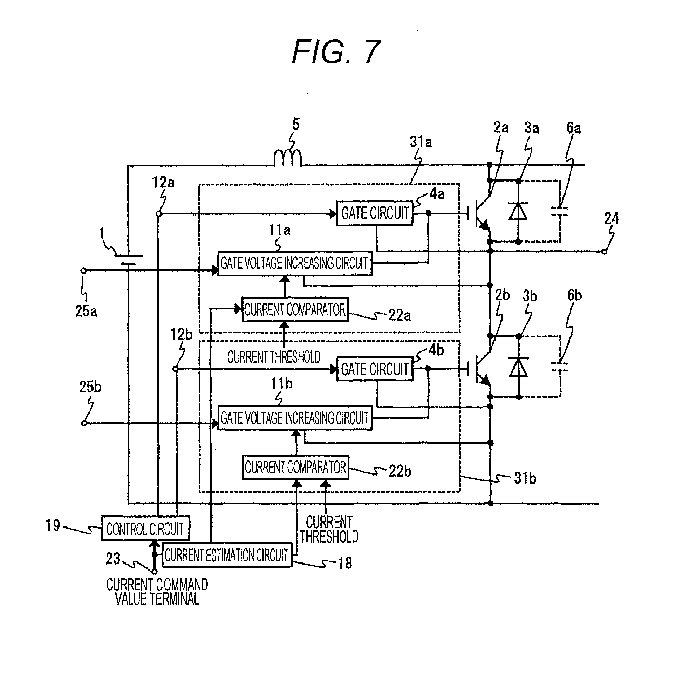

FIG. 7 is a view illustrating a power conversion circuit and a drive circuit of a different embodiment of the present invention. In the following, a point different from the described embodiments in FIG. 1, FIG. 4, and FIG. 5 will be described.

In the present embodiment, instead of the current sensor and the current detector in the embodiment in FIG. 5, a current estimation circuit 18 is used to control a gate voltage increasing circuit. The current estimation circuit 18 estimates a current value of a switching current based on a current command value given to a current command value terminal 23 of a control circuit 100 which creates a switching signal for gate control signal terminals 12a and 12b. A current comparator 22a included in a drive circuit 31a compares an estimation value of the switching current indicated by an output signal from the current estimation circuit 18 and a current threshold set in advance. When determining that the estimation value of the switching current is equal to or larger than the current threshold, the current comparator 22a creates a control signal to enable an operation of a gate voltage increasing circuit 11a which operation corresponds to a short-circuit control signal given to a short-circuit control signal terminal 25a.

According to the present embodiment, by a simple circuit configuration, it is possible to control a power loss in the gate voltage increasing circuit while controlling a peak value of a voltage change rate or a surge voltage and ringing effectively.

Note that, as the control circuit 100, a publicly-known pulse width modulation control circuit or the like can be used.

In the above, embodiments of the present invention have been described in detail but are not limited to the described embodiments. Various embodiments are possible within the technical spirit of the present invention. For example, as a semiconductor material to be a base material of an SBD, other than SiC, a wide-gap semiconductor, which has a band gap larger than that of Si, such as GaN or diamond can be applied. Also, as a semiconductor switching element which configures upper and lower arms of a power conversion circuit, other than an IGBT, a voltage-controlled semiconductor switching element such as a metal oxide semiconductor field effect transistor (MOSFET) or a static induction transistor (SIT) can be applied. Note that a semiconductor material to be a base material of the semiconductor switching element may be any of Si and wide-gap semiconductors.

### Reference Signs List

- 1: DC power source
- 2a: IGBT (upper IGBT)
- 2b: IGBT (lower IGBT)
- 3a, 3b: SiC-SBD
- 3A, 3B: Si-PiN diode
- 4a, 4b: gate circuit
- 5: inductance
- 6a, 6b: capacitor (junction capacitance)
- 11a, 11b: gate voltage increasing circuit
- 12a, 12b: gate control signal terminal
- 13a, 13b: detection circuit
- 17a, 17b: one-shot circuit
- 18: current estimation circuit
- 19: control circuit
- 21a, 21b: current detector
- 22a, 22b: current comparator
- 23: current command value terminal
- 24: AC output terminal
- 25a, 25b: short-circuit control signal terminal
- 31a, 31b: drive circuit
- 41a, 41b: switch for a gate circuit
- 42: switch for short-circuit control
- 43: gate circuit power supply in an on-state
- 44: gate circuit power supply in an off-state
- 45: power supply for a gate voltage increasing circuit
- 46: on-side gate resistance
- 47: off-side gate resistance
- 48: resistance for a gate voltage increasing circuit
- 50: current sensor

## Claims

1. A drive circuit of a semiconductor switching element, the drive circuit being configured to control a gate voltage of a semiconductor switching element in each of upper and lower arm circuits in each of which a Schottky barrier diode including a wide-gap semiconductor material as a base material is connected as a freewheel diode in parallel with the semiconductor switching element, the drive circuit comprising:
a gate voltage increasing circuit configured to make, in a period since a gate voltage of the semiconductor switching element in one of the upper and lower arms starts being increased from a value in an off-state until the gate voltage reaches a value in an on-state, a gate voltage of the semiconductor switching element in the other one of the upper and lower arms change from a value in an off-state into a value larger than the value in the off-state and configured to control the value larger than the value in the off-state for a predetermined period of time.

2. The drive circuit of a semiconductor switching element according to claim 1, wherein the gate voltage increasing circuit applies a positive voltage lower than a gate threshold voltage to a gate of the semiconductor switching element in the other one of the upper and lower arms for the predetermined period of time.

3. The drive circuit of a semiconductor switching element according to claim 1 or 2, wherein after the predetermined period of time, the gate voltage increasing circuit controls the gate voltage of the semiconductor switching element in the other one of the upper and lower arms to the voltage in the off-state.

4. The drive circuit of a semiconductor switching element according to any one of claims 1 to 3, further comprising a one-shot circuit configured to control a time of the predetermined period of time.

5. The drive circuit of a semiconductor switching element according to claims 1 to 4, further comprising a current sensor configured to detect a current flowing in the semiconductor switching element,
wherein when a current value detected by the current sensor is equal to or larger than a current threshold set in advance, an operation of the gate voltage increasing circuit is enabled.

6. The drive circuit of a semiconductor switching element according to claims 1 to 4, further comprising a current estimation circuit configured to estimate a current flowing in the semiconductor switching element based on a current command value signal for generating an on/off signal of the switching element, wherein when a current value estimated by the current estimation circuit is equal to or larger than a current threshold set in advance, an operation of the gate voltage increasing circuit is enabled.

7. A power conversion circuit comprising:
upper and lower arm circuits in each of which a Schottky barrier diode including a wide-gap semiconductor material as a base material is connected as a freewheel diode in parallel with a semiconductor switching element; and
a drive circuit configured to control a gate voltage of the semiconductor switching element in each of the upper and lower arms,
wherein the drive circuit is the drive circuit of a semiconductor switching element according to any one of claims 1 to 6.
